Europäisches Patentamt

**European Patent Office**

Office européen des brevets

(11) Publication number: **0 187 226**
**B1**

(12) **EUROPEAN PATENT SPECIFICATION**

(45) Date of publication of patent specification: **31.01.90**

(51) Int. Cl.⁵: **H 01 J 37/34**

(21) Application number: **85114424.6**

(22) Date of filing: **13.11.85**

(54) Sputtering apparatus with film forming directivity.

(30) Priority: **14.11.84 JP 238354/84**
**14.11.84 JP 238358/84**

(43) Date of publication of application:
**16.07.86 Bulletin 86/29**

(45) Publication of the grant of the patent:
**31.01.90 Bulletin 90/05**

(84) Designated Contracting States:
**DE FR NL**

(56) References cited:
**EP-A-0 144 572**
**EP-A-0 154 859**
**US-A-4 401 546**

**IBM TECHNICAL DISCLOSURE BULLETIN, vol. 20, no. 2, July 1977, page 756, New York, US; T.N. KENNEDY: "Chevron sputtering catcher"**

**JOURNAL OF PHYSICS E, SCIENTIFIC INSTRUMENTS, vol. 12, no. 3, March 1979, pages 159-167, The Institute of Physics, London, GB; J.L. VOSSEN: "The preparation of substrates for film deposition using glow discharge techniques"**

(73) Proprietor: **HITACHI, LTD.**
**6, Kanda Surugadai 4-chome Chiyoda-ku Tokyo (JP)**

(72) Inventor: **Sakata, Masao**
**Fujimi-ryo, 1545 Yoshida-cho Totsuka-ku Yokohama-shi Kanagawa-ken (JP)**
Inventor: **Shimamura, Hideaki**
**810, Harajuku-cho Totsuka-ku Yokohama-shi Kanagawa-ken (JP)**
Inventor: **Kobayashi, Shigeru**
**1-31-3, Hanegi Setagaya-ku Tokyo (JP)**
Inventor: **Kawahito, Michiyoshi**
**147-6, Naganuma-cho Totsuka-ku Yokohama-shi Kanagawa-ken (JP)**
Inventor: **Kamei, Tsuneaki**
**382, Yamanishi Ninomiya-machi Naka-gun Kanagawa-ken (JP)**
Inventor: **Abe, Katsuo**
**5-2-12, Take Yokosuka-shi Kanagawa-ken (JP)**

(74) Representative: **Patentanwälte Beetz sen. - Beetz jun. Timpe - Siegfried - Schmitt-Fumian Steinsdorfstrasse 10 D-8000 München 22 (DE)**

## Description

### Background of the invention
### (1) Field of the invention

The present invention relates to a planar magnetron sputtering apparatus which forms a thin film by the use of sputtering. More particularly, it relates to a sputtering apparatus of good step coverage by which a substrate to be formed with a film and having a microscopic through-hole or the like as the shape of a stepped part can be formed with the thin film faithfully matching to the shape.

### (2) Description of the prior art

A conventional planar magnetron sputtering process is described in detail in, for example, a paper by John L. Vossen, Werner Kern et al. contained in "Thin Film Processes", Academic Press, 1978.

A material to be sputtered is sputtered and scattered by an inert atomic species heavier than a hydrogen atom, such as Ar, thereby to reach a substrate on which a film is to be formed. The directions of the scattering are controlled according to the cosine law. Therefore, when a stepped part exists on the substrate to be formed with the film, overhangs are formed on the side walls of the step.

The actual film formation by the sputtering is employed for the production of semiconductor devices (ICs, LSIs, etc.) and various thin-film modules (thermal recording heads, etc.). More concretely, it is important as a technique for forming an interconnection layer, a conductor layer and an insulator layer.

As described in, for example, a paper "Vacuum Evaporation and Sputtering Apparatus" by Kitabayashi et al. in 'Denshi Zairyo (Electronics Material)', 1981, Separate Volume, pp. 143—148, there has been developed an apparatus in which a plasma is confined into the vicinity of target by an electromagnetic field, thereby to efficiently form a film.

Besides, in a paper "Planar Magnetron Sputtering Cathode with Deposition rate Distribution Controllability" by Abe et al. in 'Thin Solid Film', Vol. 96 (1982), pp. 225—233, a double magnetic pole type electromagnet cathode structure is introduced. Here, it is disclosed that a semiconductor substrate of large diameter (φ150 mm) can be formed with a uniform film by operating two electromagnets to control an electromagnetic field distribution and to change an erosion diameter at will.

Even with the techniques as mentioned above, however, the microminiaturization of patterns has been attended with the problem that, in a through-hole portion or the like in the case of forming the upper layer of a multilayer interconnection or an object to be formed with a film, already having an interconnection as an under layer, the step covered becomes insufficient to cause a part where no film is formed.

EP—A—0154859 (prior art in the sense of Article 54(3) EPC) discloses a planar magnetron sputtering apparatus for vacuum depositing a thin layer of material on the surface of a substrate. The apparatus includes a vacuum chamber which is filled with an ionizable inert gas, which may be argon, i.e. a rare gas, at a pressure in the range of approximately 0.065 to 0.26 Pa, means for maintaining a predetermined flow rate of the rare gas, a sputtering target attached to a cathode, and a power supply, which may be an RF power supply, connected to the cathode for producing an electric field to generate the plasma. Magnetic field generating means retain the plasma in a predetermined position relative to the target, a substrate is arranged with its upper surface, which is to be coated with a sputtered film, opposite to the target and supported by substrate holding means. Shields are placed between the cathode assembly and the substrate in such a manner as to block a portion of the atoms sputtered from the target und to prevent them from impinging on the surface.

### Brief summary of the invention

An object of the present invention is to provide an apparatus which performs sputtering film formation of favorable step coverage. More in detail, it is to provide a planar magnetron sputtering apparatus in which, in order to form a film on a stepped portion having a microscopic through-hole as per the shape of the underlying step, sputtering particles with a directivity are caused to fly onto a substrate for the film formation, thereby making it possible to form the film faithfully matching to the shape of the step.

Said object is solved, according to the present invention, by a planar magnetron sputtering film formation apparatus for enabling formation of multilayer interconnection having fine steps in a semiconductor device, comprising evacuation means to establish and maintain a predetermined negative pressure environment which is required for generating a plasma to induce a sputtering phenomenon; rare gas supply means to introduce a rare gas for principally generating the plasma and to hold a predetermined flow rate of the rare gas; power feed means to feed electric power which serves principally to excite the rare gas and to generate the plasma to induce the sputtering phenomenon; a target which is bombarded by constituent particles of the rare gas on the basis of the sputtering phenomenon, to emit sputtering particles as a material for forming a film; magnetic field generation means to hold the generated plasma at a predetermined position of said target; a substrate holder which holds a substrate to be formed with the film and arranged in opposition to said target, and wall means being interposed between the substrate to be coated with the film and a major surface of said target opposed to the substrate, said wall means being disposed adjacent said substrate and comprising a regular grid with apertures bounded by wall portions substantially perpendicular to said substrate, so as to prevent the formation of film layer overhang portions on the fine steps of the via-holes for the multi-layer interconnection of the semiconductor device by blocking the flight paths of sputtered particles emitted at angles to the normal to said major surface of said target greater than a predetermined value.

Brief description of the drawings

Fig. 1 is a view showing an embodiment of the present invention;

Fig. 2 is a sectional view showing the step of a substrate for film formation before a film is formed;

Figs. 3 and 4 are sectional views for explaining steps after films have been formed;

Figs. 5 to 9 are views each showing a modification of a recess formed in a recess in a target in Fig. 1;

Fig. 10 is a front view showing the distribution of the recesses formed in the target in Fig. 1;

Fig. 11 is a view showing modifications of the front shape of the recess formed in the target in Fig. 1;

Fig. 12 is a front view showing another example of the distribution in Fig. 10;

Fig. 13 shows a front view and a sectional view of pillars which define a configuration equivalent to that of the recesses formed in the target in Fig. 1;

Fig. 14 shows another modification of the recesses referred to in Fig. 13;

Fig. 15 is a conceptual view showing another embodiment of the present invention;

Fig. 16 is a schematic sectional view of the sputtering apparatus in Fig. 15;

Fig. 17 is a schematic plan view of the vicinity of a substrate holder in Fig. 15;

Fig. 18 is a view for explaining a cycloidal motion;

Fig. 19 is a view for explaining a magnetron discharge in a target recess;

Fig. 20 is an explanatory view of the impartation of a directivity to sputtering particles by a holed target; and

Fig. 21 is a schematic view of a sputtering apparatus in a prior art.

Detailed description

In order to promote a better understanding of the present invention, the description of the present invention will be started from some explanation of the principles of the sputtering technique.

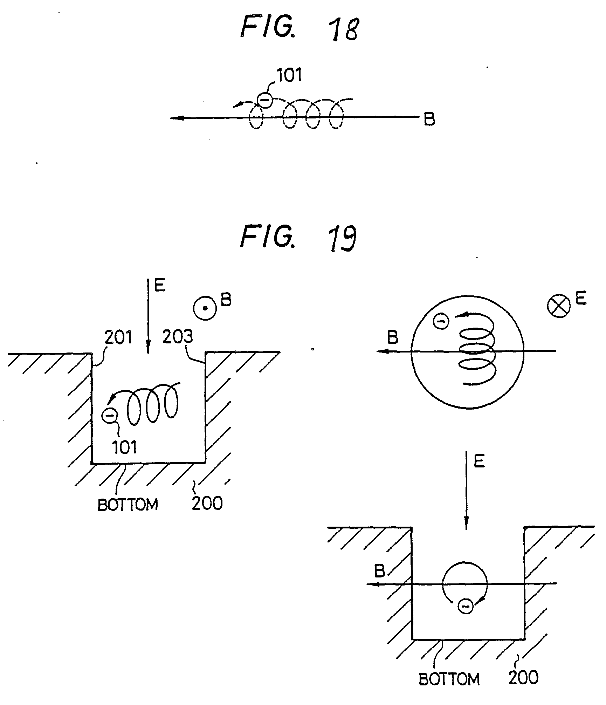

(A) In a sputtering apparatus, a glow discharge must be maintained within a space of reduced pressure. An electron generated by the discharge performs a helical motion so as to wind around a magnetic field vector IB (Fig. 18). Therefore, the mean free path (hereinbelow, abbreviated to 'mfp') of the electcon lengthens. This effect increases the probability of the collision of the electron with the particles of a sputtering gas (usually, the particles of an inert gas such as argon gas), to generate an intense glow discharge. In a hole in a target member shown in Fig. 19, an electron moves to the bottom thereof owing to a magnetron motion based on a magnetic field IB and an electric field IE. This electron performs the magnetron motion also in the bottom portion of the hole. More specifically, when the electron 101 has approached a hole side wall 201, it is repelled by the electric field of the target at a great negative potential and is pushed back in the direction opposite to that of the magnetron motion. However, the electron is advanced toward the hole side wall 201 by the force of the magnetron motion again, whereupon it is pushed back under the repulsive force of the electric field again. It continues such motions. Therefore, the mfp enlarges, and the intense glow discharge can be sustained even under a pressure of or below 0.13 Pa ($10^{-3}$ Torr) which is a pressure in ordinary sputtering.

Since, in this manner, the glow discharge arises also within the recess provided in the target member, it has become possible to endow the emission directions of the sputtering particles with a directivity by means of the target member provided with the recesses as one embodiment of the present invention.

More specifically, the discharge concentrates in the hole bottom portion, it concentrates in the hole, and the sputtering phenomenon is induced by the gas ionized positive within the hole. In this regard, the sputtering particles which are emitted according to the ordinary cosine law within the hole have the emission angle distribution thereof limited in accordance with a solid angle defined when a space above the principal surface of the target is viewed from within the hole.

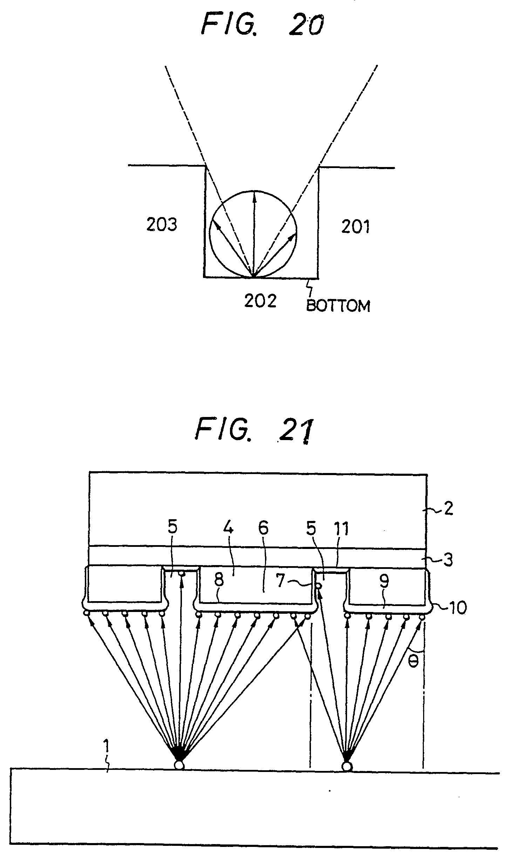

Fig. 20 illustrates that the angle of emission of sputtering particles from one point of the hole bottom conforms with the cosine law if side walls are not provided, but that the sputtering particles are blocked by the hole side walls 201 and 203 to undergo an angular distribution. The hole side walls 201 and 203 are accordingly consumed by sputtering, but the particles sputtered from the hole bottom deposit thereon, so that the open diameter of the hole does not enlarge due to the sputtering. Therefore, the directivity imparted to the sputtering particles remains unchanged, and none of an overhang shape etc. arises on the stepped portion of a substrate for film formation at all times, so that favorable film characteristics can be maintained.

(B) As already stated, in the case where the stepped portion exists on the substrate to be formed with the film, the inferior step coverage of the stepped portion is attributed to the fact that the entrance of the sputtering particles on the substrate conforms with the cosine law. That is, the sputtering particles entering the substrate perpendicularly are smaller in number than the particles entering the same at any other angles, so that overhangs are formed on the stepped portion to worsen the step coverage.

Accordingly, it is necessary for improving the step coverage to endow the emission source of sputtering particles with a directivity or to limit the angle of entrance of sputtering particles to enter a substrate for film formation.

The worsening of the coverage ascribable to the cosine law will be described with reference to Fig. 21.

In Fig. 21, a target material is sputtered from a sputtering target 1 to a wafer 2. This wafer is previously formed with a first layer of interconnection 3, an inter-layer insulator film 4, and through-holes 5 provided in the inter-layer insulator film 4. The angle of incidence of a sputtering particle on the wafer, with respect to a line perpendicular to the plane of the wafer is denoted by θ as indicated in this figure. Here, let's consider the formation of a film on a stepped portion 6 defined by the through-holes 5. On the side surface 7 of the stepped portion 6, no particle enters the wafer from a target part lying on the left side of a line which is drawn perpendicularly from a point on the side surface 7 to the target 1, so that the nubmer of incident particles on the side surface 7 is naturally smaller than on the top surface part 8 of the step. Consequently, the amount of film formation on the step top surface 8 becomes larger, and the particles having incided and deposited on the step top surface as indicated at numeral 9 Fig. 21 form overhang parts 10. When the overhang parts have been formed, the number of the incident particles on the side surface 7 decreases more. In addition, the size of the through-hole 5 is often set at a value equal to or smaller than the thickness of the insulator film 4. In such a case, also the number of incident particles on the bottom part 11 of the through-hole decreases on account of the stepped portion 6 and the overhang parts 10.

These phenomena arise because of the larger amount of film formation based on the incident particles whose angles θ indicated in Fig. 21 are large, and by removing the particles incident at the large angles θ, the improvement of the coverage is achieved as indicated by another embodiment of the present invention. To this end, as shown in Fig. 15, a frame or grid 12 is disposed in the space between a target 1 and a wafer 2 to remove the incident particles of large angles θ.

In Fig. 15, substrate parts (2, 3, 4) are depicted in μm in the thickness direction thereof, and the other parts are depicted in mm. That is, the substrate parts are magnified to 1,000 diameters in the thickness direction as compared with the other parts.

When the grid or frame 12 is provided as shown in Fig. 15, there arise the problems of (1) decrease in the rate of film formation on the wafer and (2) lowering in the amount of film formation in a part 13 shaded by the frame. The new problems are solved by contriving (1) a measure wherein a substrate such as the wafer is continuously rotated or moved in parallel, thereby to control a film thickness distribution within the substrate, (2) a measure wherein currents which are applied to electromagnets 15 being magnetic field generation means are changed, thereby to effectively utilize the target material, and so forth.

(C) Now, embodiments of the present invention will be described with reference to the drawings.

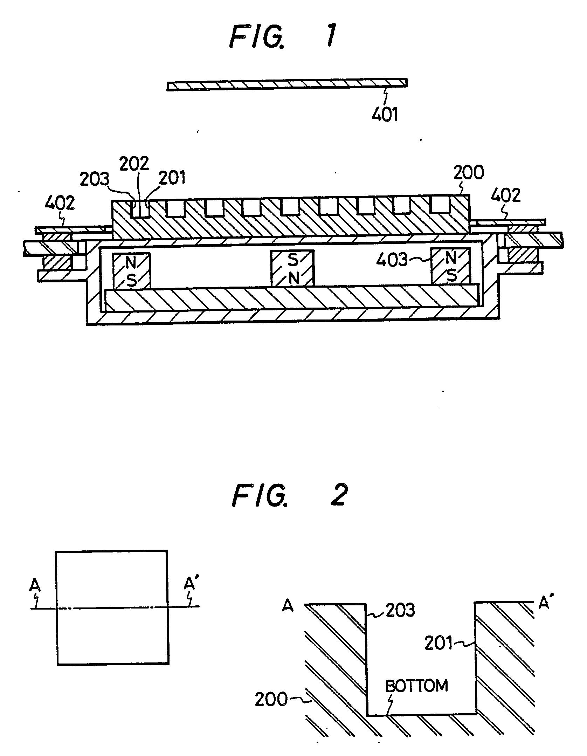

Fig. 1 shows a sectional view of a planar magnetron sputtering apparatus which is the first embodiment. An evacuation system, a radio frequency power source, etc. which are not pertinent to the present invention are not shown. Referring to Fig. 1, the sputtering apparatus has a holed target made of Al 200 and employs a permanent magnet 403 as magnetic field generation means. The permanent magnet 403 generates a magnetic field orthogonal to an electric field which enters perpendicularly to the principal plane of the target 200 and the plane of the bottom 202 of each hole. Numeral 401 in the figure designates a substrate to be formed with a film, and numeral 402 an anode. Using the embodiment shown in Fig. 1, argon gas is introduced into the space between the target 200 and the substrate for film formation 401, and a great negative voltage is applied to the target 200 to induce the glow discharge, and to sputter the target 200, whereby sputtering particles of the target material are formed as the thin film on the substrate for film formation 401.

The function and effect of the present embodiment will be described below.

Fig. 2 shows the shape of the through-hole of the substrate for film formation (dimensions of the through-hole: 1.5 μm×1.5 μm, dimension of a step: 1.5 μm).

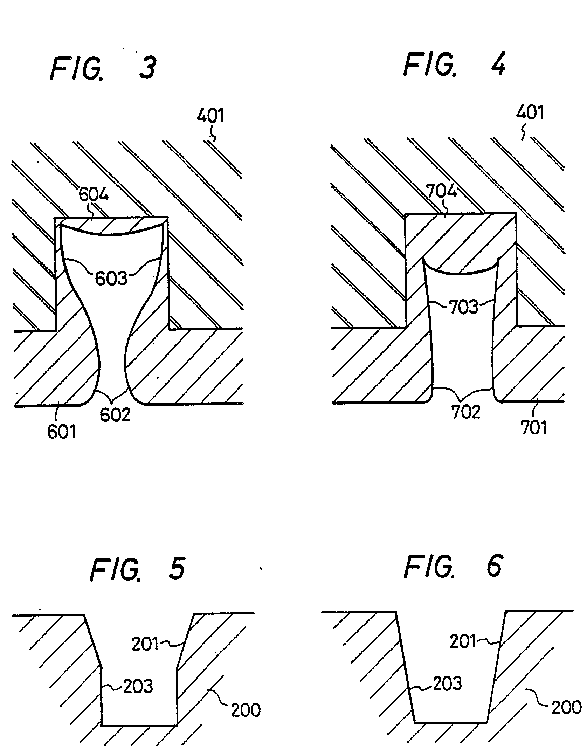

Fig. 3 shows a result obtained when the through-hole portion shown in Fig. 2 was formed with a film 1 μm thick without employing the holed target according to the present invention. The Al film 601 exhibited the shape of an overhang 602 at the stepped part of the through-hole, and it was hardly formed on the side walls 603 of the through-hole and the bottom 604 thereof.

Fig. 4 shows a shape obtained when an Al film was formed by 1 μm by the use of the embodiment shown in Fig. 1. In this case, the Al film 701 scarcely formed an overhang at the stepped part 702 of the through-hole, and Al films 0.3 μm and 0.8 μm thick were respectively formed on the side walls 703 of the through-hole and the bottom 704 thereof.

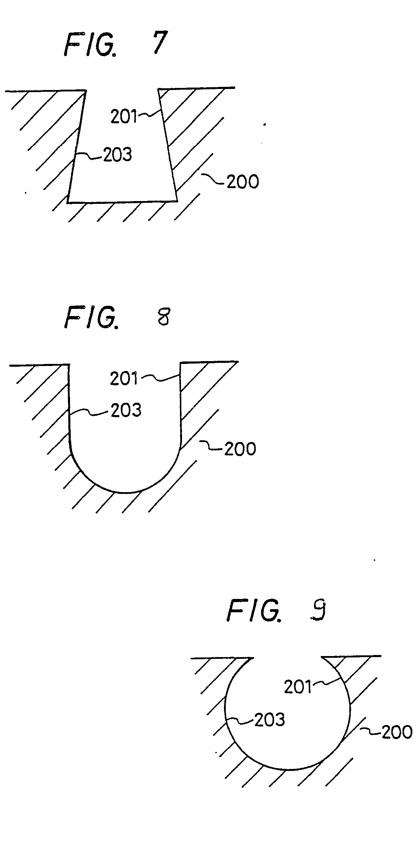

Figs. 5 to 9 show modifications of the present embodiment. They illustrate the sectional shapes of holed targets (corresponding to the element 200 in Fig. 1) for use in the present embodiment.

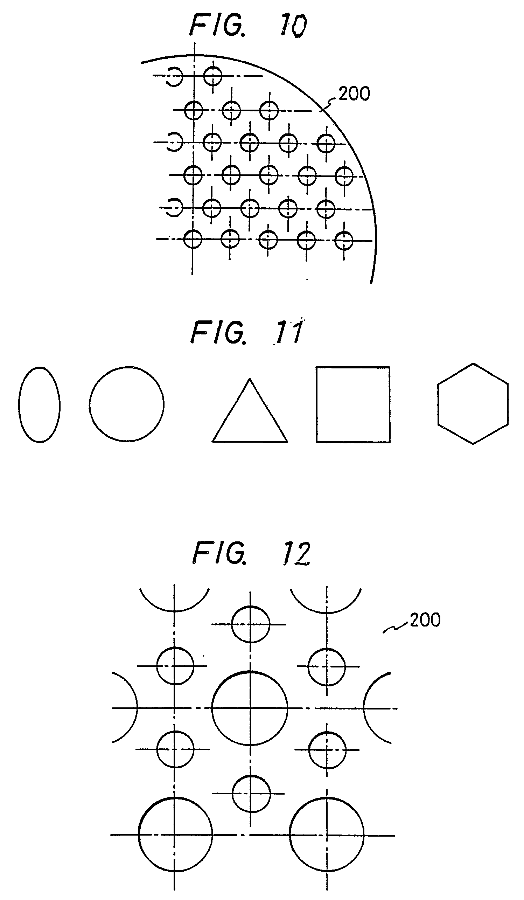

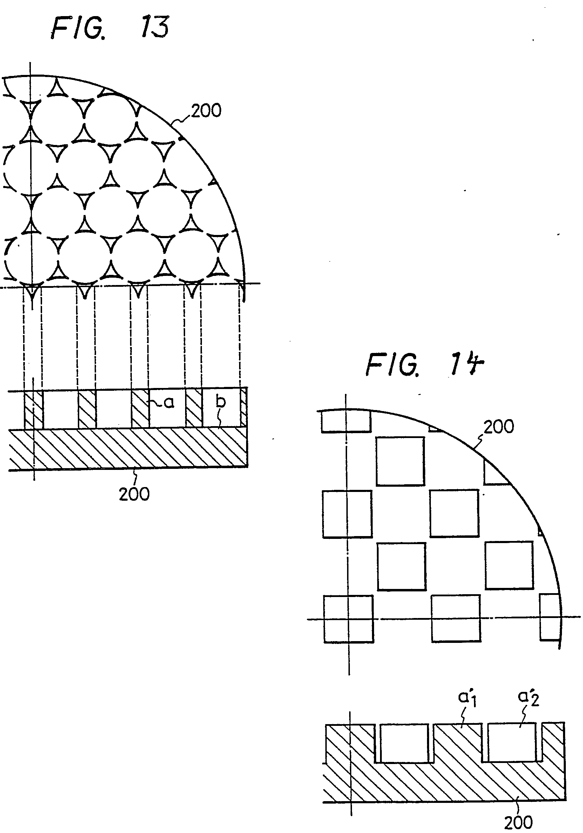

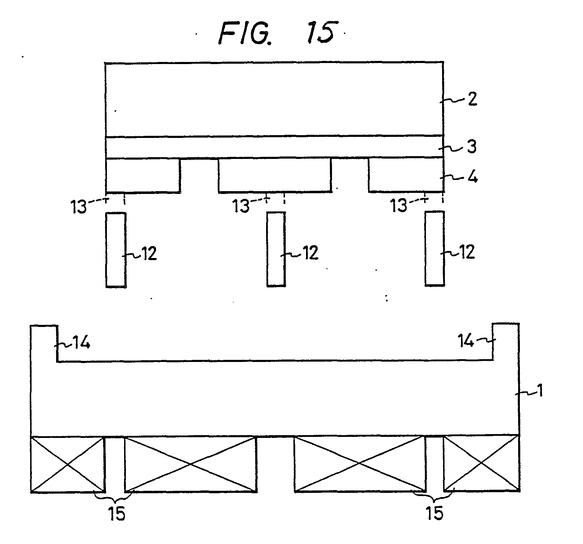

Fig. 10 shows the arrangement of the holes in the target, while Fig. 11 shows modifications of the shapes of the holes of the target viewed in plan. In order to increase the area of the recesses in the target, larger and smaller recesses may be combined as illustrated in Fig. 12, or columnar protrusions may be formed on the upper side of the target to equivalently form holes as illustrated in Fig. 13 or Fig. 14.

According to the present embodiment, the directivity of the sputtering particles which fly and come from the target member is enhanced, and favorable film deposition characteristics free from the overhang shape can be attained.

By way of example, when a stepped portion corresponding to a through-hole 2 μm in diameter and 2 μm in depth is formed with a film at a film formation rate of approximately 0.8 μm/minute, the film is deposited to a thickness of 0.4 μm on the side walls of the stepped portion, and favorable film deposition characteristics free from an overhang shape can be attained.

Figs. 15 to 17 show an embodiment in which a grid or frame is disposed directly in front of a substrate to the end of limiting the incident angle of sputtering particles that enter the substrate for film formation.

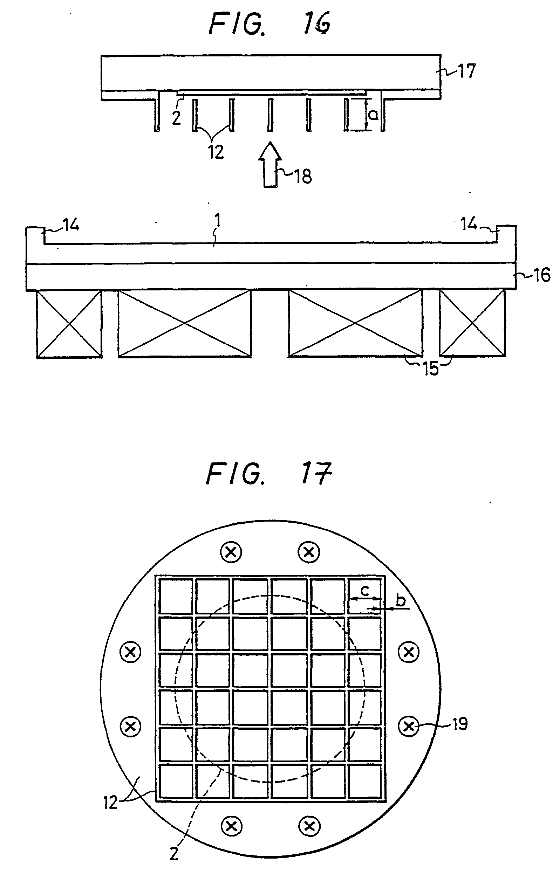

Let's exemplify a case where an Al film 1 μm thick as a first layer of interconnection and a polyimide film 2 μm thick as an inter-layer insulator film are successively formed on a silicon wafer of φ 100 mm (100 mm in diameter) and where through-holes of φ2 μm are formed in the polyimide resin. The resulting wafer is set in the sputtering apparatus of the present embodiment illustrated in Figs. 16 and 17. In this case, Fig. 16 is a sectional view of a target part and a substrate holder part within the sputtering apparatus, while Fig. 17 is a view of the substrate holder part seen in the direction of an arrow 18 in Fig. 16. The sputtering apparatus shown in Figs. 16 and 17 is such that a target 1 which is of 260 mm φ and which is made of Al is formed at its peripheral part with a rim 14 having a height of 10 mm, and that it is bonded to a backing plate 16. Besides, electromagnets 15 are arranged on the rear surface of the backing plate 16 and are shaped into a double ring, and currents applied to the respective electromagnets can be changed independently of each other. In addition, the silicon wafer 2 is set on a substrate holder 17, to which the grid or frame 12 is thereafter fixed by screws 19. By way of example, the frame 12 was so shaped that the height a (Fig. 16) thereof was 19 mm and that the frame width b (Fig. 17) thereof was 0.5 mm, and each subdivision defined by the frame was in the shape of a regular square one side c (Fig. 17) of which was 19.5 mm. The distance between the wafer and the plane of the target was 80 mm. With this sputtering apparatus, the target material was sputtered for 1 minute and 25 seconds under the conditions that the gaseous pressure of Al to be sputtered was 0.39 Pa (3 mTorr), that a voltage applied to the target was 500—600V, that a target current was 12A, and that the currents applied to the electromagnets 15 were 3—6 A for the inner electromagnet (1350 turns) and 8—0A for the outer electromagnet (350 turns). During the sputtering, the substrate holder 17 was rotated while being moved in parallel with the plane of the target 1. As a result, the Al film was formed to a thickness of 1.0 μm on the upper surface part of the through-hole step and to a thickness of 0.9 μm on the bottom of the through-hole, and an uncovered part on the side surface of the stepped portion did not arise. For the sake of comparison, using the prior-art sputtering apparatus which was not furnished with the grid or frame 12 and the rim 14 of the target, the target material was sputtered for 50 seconds under the same sputtering conditions as mentioned above. As a result, the deposited Al film was 1.0 μm thick on the top surface of the through-hole step and 0.6 μm thick on the bottom of the through-hole, the overhang part as shown in Fig. 21 was formed, and uncovered parts appeared on the side surfaces of the step.

In Fig. 21, the substrate is depicted on enlarged scale in the thickness direction thereof. More concretely, dimensions in the thickness direction of the substrate are taken in μm, and the other dimensions in mm.

It is understood that the uniform film formation can be carried out by disposing the grid or frame according to the present embodiment, but the rate of film formation lowers to some extent. This is ascribable to the fact that, since the particles emitted from the target material are blocked by the grid or frame, the total quantity of sputtering particles to reach the silicon wafer decreases. By properly selecting the configuration of the grid or frame, accordingly, the step coverage can be improved without extremely lowering the film formation rate. Grids or frames may be changed according to the use of the film formation.

According to the present embodiment, step coverage for a microscopic through-hole portion can be performed without an uncovered part, to bring forth the effect of permitting the formation of a multi-layer interconnection portion of favorable connection reliability in semiconductor devices etc. to be microminiaturized still more. Another effect is that a target which has heretofore required an area about four times larger than the area of a substrate can be rendered substantially as small as the substrate, thereby to sharply enhance the utilization factor of the target.

## Claims

1. A planar magnetron sputtering film formation apparatus for enabling formation of multilayer interconnection having fine steps in a semiconductor device, comprising:

evacuation means to establish and maintain a predetermined negative pressure environment which is required for generating a plasma to induce a sputtering phenomenon;

rare gas supply means to introduce a rare gas for principally generaging the plasma and to hold a predetermined flow rate of the rare gas;

power feed means (402) to feed electric power which serves principally to excite the rare gas and to generate the plasma to induce the sputtering phenomenon;

a target (200; 1) which is bombarded by constituent particles of the rare gas on the basis of the sputtering phenomenon, to emit sputtering particles as a material for forming a film;

magnetic field generation means (403) to hold the generated plasma at a predetermined position of said target;

a substrate holder (17) which holds a substrate (401; 2) to be formed with the film and arranged

EP 0 187 226 B1

in opposition to said target (200; 1); and wall means being interposed between the substrate (2) to be coated with the film and a major surface of said target (1) opposed to the substrate (2), said wall means being disposed adjacent said substrate and comprising a regular grid (12) with apertures bounded by wall portions substantially perpendicular to said substrate (2), so as to prevent the formation of film layer overhang portions on the fine steps of the via-hole for the multi-layer interconnection of the semiconductor device by blocking the flight paths of sputtered particles emitted at angles to the normal to said major surface of said target (1) greater than a predetermined value.

2. A sputtering apparatus according to Claim 1, characterized in that said wall portions comprise side walls (201, 203) of recesses which are formed in said target (200) itself.

3. A sputtering apparatus according to Claim 1, characterized in that said target (1) has an upstanding rim (14) at an outer peripheral part thereof.

4. A sputtering apparatus according to Claim 1, characterized in that said substrate holder (17) provides means for moving said substrate (2) in parallel with the surface of the target (1).

**Patentansprüche**

1. Planar-Magnetron-Zerstäubungsvorrichtung zur Herstellung von Filmen für Mehrschichtverbindungen mit feinen Stufen in einer Halbleitervorrichtung mit

einer Evakuierungsvorrichtung zur Erzeugung und Aufrechterhaltung eines vorbestimmten, für die Erzeugung eines Plasmas und Induzierung einer Zerstäubung notwendigen Vakuums,

einer Zufuhrvorrichtung für Edelgas, im wesentlichen zur Erzeugung des Plasmas und Aufrechterhaltung eines vorbestimmten Durchsatzes des Edelgases,

Zufuhrvorrichtungen (402) für elektrischen Strom, im wesentlichen zur Anregung des Edelgases und Erzeugung des Plasmas und Induzierung der Zerstäubung,

einem Target (200; 1), das mit das Edelgas bildenden Teilchen durch Zerstäubung zur Emission von zerstäubten Teilchen als Material für die Bildung eines Films bombardiert wird,

einer Vorrichtung zur Erzegung eines Magnetfelds (403) zum Halten des erzeugten Plasmas in einer vorbestimmten Stellung des Targets,

einem Substrathalter (17) der das mit einem Film zu beschichtende Substrat (401; 2) gegenüber dem Target (200; 1) hält und

Wandvorrichtungen zwischen dem mit dem Film zu beschichtenden Substrat (2) und einer Hauptfläche des Targets (1) gegenüber dem Substrat (2), wobei diese Wandvorrichtungen in der Nähe des Substrats angebracht sind und ein regelmäßiges Gitter (12) mit Öffnungen umfaßen, die durch im wesentlichen zum Substrat (2) senkrechte Wandbereiche verbunden sind, so daß die Bildung einer über die Bereiche der feinen Stufen der Durchgangslöcher der Mehrschichtverbindungen der Halbleitervorrichtung überhängenden Filmschicht vermieden wird durch Blockieren der Flugbahnen von zerstäubten Teilchen, die mit einem Winkel zur Normalen der Hauptfläche des Targets (1) über einen vorbestimmten Wert emittiert werden.

2. Zerstäubungsvorrichtung nach Anspruch 1, dadurch gekennzeichnet, daß die Wandbereiche Seitenwände (201; 203) von Vertiefungen, die im Target (200) selbst gebildet sind, sind.

3. Zerstäubungsvorrichtung nach Anspruch 1, dadurch gekennzeichnet, daß das Target (1) an seiner Peripherie einen aufstehenden Rand (14) aufweist.

4. Zerstäubungsvorrichtung nach Anspruch 1, dadurch gekennzeichnet, daß der Substrathalter (17) Mittel zur Bewegung des Substrats (2) parallel zur Fläche des Targets (1) umfaßt.

**Revendications**

1. Dispositif de formation d'un film par pulvérisation à magnétron planaire en vue de permettre la réalisation d'une interconnexion à couches multiples possédant des échelons minces dans un dispositif à semiconducteurs, comportant:

des moyens pour faire le vide en vue d'établir et de maintenir un environnement de pression négative prédéterminé qui est nécessaire pour générer un plasma en vue de provoquer un phénomène de pulvérisation;

des moyens d'alimentation en gaz rare pour introduire un gaz rare pour générer principalement le plasma et maintenir un débit prédéterminé du gaz rare;

des moyens d'alimentation (402) pour délivrer l'énergie électrique servant principalement à exciter le gaz rare et à générer le plasma en vue de provoquer le phénomème de pulvérisation;

une cible (200; 1) qui est bombardée par des particules constituantes du gaz rare à partir du phénomène de pulvérisation, pour émettre des particules de pulvérisation en tant que matériau devant former un film;

des moyens de génération d'un champ magnétique (403) pour maintenir le plasma généré en une position prédéterminée de ladite cible;

un support de substrat (17) maintenant un substrat (401; 2) sur lequel doit être formé le film et disposé en face de ladite cible (200; 1); et des moyens formant une paroi interposés entre le substrat (2) à revêtir du film et une surface principale de ladite cible (1) en face du substrat (2), lesdits moyens formant une paroi étant disposés adjacents audit substrat et comportant une grille régulière (12) avec des ouvertures limitées par des parties de paroi sensiblement perpendiculaires audit substrat (2), de façon à empêcher la formation de parties en surplomb de la couche de film sur les échelons minces de l'interconnexion entre couches pour l'interconnexion à couches multiples du dispositif à semiconducteurs en bloquant les trajectoires de particules pulvérisées émises selon des angles par rapport à la normale à ladite surface principale de ladite cible (1) supérieurs à une valeur prédéterminée.

2. Dispositif de pulvérisation selon la revendication 1, caractérisé en ce que lesdites parties de paroi comportent des parois latérales (201, 203) d'évidements qui sont pratiqués dans ladite cible (200) elle-même.

3. Dispositif de pulvérisation selon la revendication 1, caractérisé en ce que ladite cible (1) possède un bord vertical (14) en une partie extérieure de sa périphérie.

4. Dispositif de pulvérisation selon la revendication 1, caractérisé en ce que ledit support de substrat (17) constitue un moyen pour déplacer ledit substrat (2) parallèlement à la surface de la cible (1).

## FIG. 1

401

202
203    201                                    200
402                                            402

N    S                S    N        403        N    S
S                     N                        S

## FIG. 2

A                    A'

A                    203            A'

201

200                  BOTTOM

FIG. 3

FIG. 4

FIG. 5

FIG. 6

FIG. 7

FIG. 8

FIG. 9

FIG. 10

FIG. 11

FIG. 12

*FIG. 13*

*FIG. 14*

## FIG. 15

FIG. 16

FIG. 17

FIG. 18

FIG. 19

## FIG. 20

203      201

202   BOTTOM

## FIG. 21